# EUROPEAN PATENT APPLICATION

(11) **EP 0 607 874 A1**
(43) Date of publication of application: **27.07.1994**
(21) Application number: 94100463.2
(22) Date of filing: 13.01.1994
(51) Int. Cl.: H01L 27/148

(54) **Solid state image sensor**

(30) Priority: 13.01.1993 JP 3710/93
(71) Applicant: NEC CORPORATION, Tokyo (JP)
(72) Inventor: Miwada, Kazuo, Minato-ku, Tokyo (JP)
(74) Representative: Glawe, Delfs, Moll & Partner

(57) **Abstract**

In a solid state image sensor in which all of a photoelectric conversion section, a transfer gate section and a charge transfer section are formed in the same N-type region, a P-type region for controlling a channel potential of the transfer gate section is formed in self-alignment with the storage gate electrode and the gate electrode of the charge transfer section. With this arrangement, since there is formed no potential well other than the potential well inherent in the transfer gate section, the movement of the electric charge is smoothly carried out, and therefore, the generation of the afterimage is effectively prevented.

## Description

### Background of the Invention

### Field of the invention

The present invention relates to a solid state image sensor, and more particularly, to a solid state image sensor which can be advantageously used in a facsimile, an image scanner, a digital copier, and the like.

### Description of related art

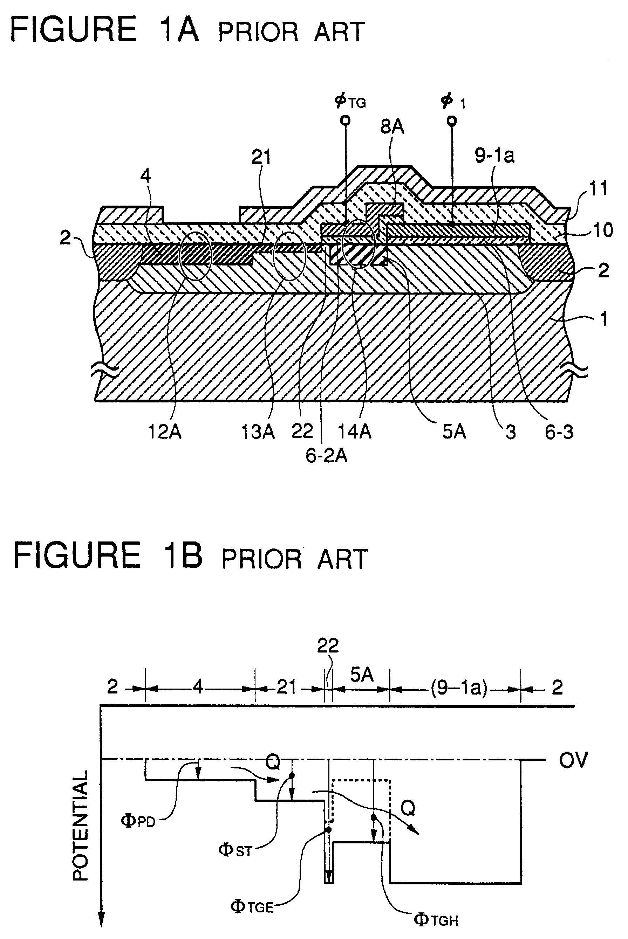

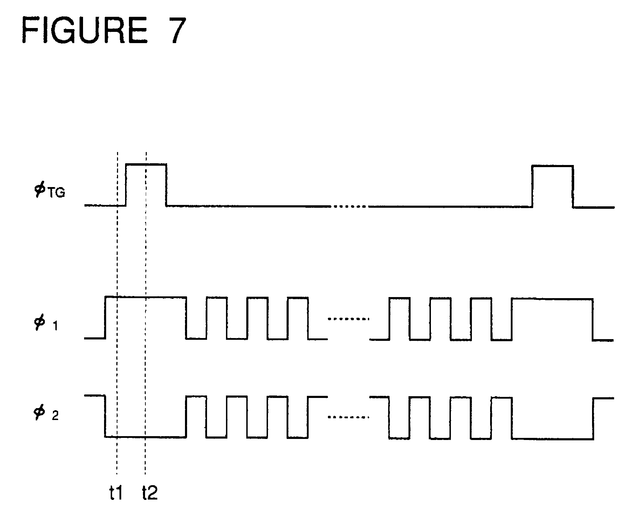

For example, JP-A-02-050480 discloses one example of conventional solid state image sensors, a sectional view of which is shown Figure 1A. In the drawing, Reference Numeral 1 shows a P-type silicon substrate, and Reference Numeral 3 designates an N-type region formed at a surface portion of the P-type silicon substrate 1. In addition, Reference Numeral 4 indicates P⁺ region which is selectively formed at a portion of a surface of the N-type region 3, and which has a concentration higher than that of the substrate 1. This P⁺ region 4, the N-type region 3 and the substrate 1 constitutes a photoelectric conversion section 12A of a PN photodiode structure. Reference Numeral 2 designates a P⁺ channel stopper region for preventing signal charges generated in the photoelectric conversion section 12A from flowing out to a region other than an electric charge storage section 13A which will be described hereinafter. Adjacent to the photoelectric conversion section 12A, there is formed a P⁺ region 21 having a PN junction at a level shallower than that formed by the P⁺ region 4. This P⁺ region 21 and the N-type region 3 constitute the electric charge storage section 13A. Because of existence of these P⁺ regions 4 and 21, the N-type region in the photoelectric conversion section 12A and the electric charge storage section 13A is depleted. In addition, Reference Numeral 10 shows an interlayer insulating film formed on the semiconductor substrate, and Reference Numeral 8A indicates a transfer gate electrode. Reference Numeral 9-1a designates a gate electrode in a CCD register section. Each of these gate electrodes 8A and 9-1a has a double layered structure. The gate electrodes 8A and 9-1a are supplied with clocks φ_{TG} and φ₁, respectively (as shown in Figure 7). A P⁻ region 5A is formed in tile substrate surface under the transfer gate electrode 8A in order to settle a channel potential of a transfer gate section 14A. The gate electrode 9-1a and a portion of the N-type region 3 under tile gate electrode 9-1a constitute a buried channel type CCD. Reference Numeral 11 designates a light shield formed on the interlayer insulating film 10 and having an opening above the photoelectric conversion section 12A.

Figure 1B is a diagram illustrating a potential profile of the substrate surface when a zero potential is applied to the P-type silicon substrate 1 and the channel stopper region 2 of the solid state image sensor, and the clocks φ_{TG} and φ₁ are applied to the gate electrodes 8A and 9-1a, respectively. In the drawing, Φ_{PD} shows a depth of a potential well of the depleted photoelectric conversion section 12A, and Φ_{TGH} indicates a potential under the transfer gate electrode 8A when the clock φ_{TG} applied to the gate electrodes 8A is at a high level "H" (the timing t₂ shown in Figure 7).

In this image sensor, signal charges Q are generated in the photoelectric conversion section 12A in response to an incident light, and then accumulated in the potential well of the electric charge storage section 13A. The accumulated signal charges Q are transferred to the region under the gate electrode 9-1a of the CCD register by opening the transfer gate (namely, by bringing the φ_{TG} to the high level "H").

The photoelectric conversion section and the electric charge storage section of the conventional solid state image sensor as mentioned above, have a structure of reducing an afterimage by depleting these sections. However, at a boundary between the charge storage section 13A and the transfer section 14A, there exists a region 22 which is positioned under the transfer gate 8A and where the P⁻ region 5A does not exist. The depth Φ_{TGE} of the potential well formed in this region 22 is larger than the depth Φ_{TGH} of the potential well of the P⁻ region 5A in the transfer gate section. Because of this configuration, when the signal charges Q are caused to flow from the charge storage section 13A to the region under the gate electrode 9-1a of tile CCD register by bringing φ_{TG} to the high level "H", the signal charges Q pass through the transfer gate section, but are partially collected in the deep potential well 22. Therefore, the time required for passing through the transfer gate section is increased, and the afterimage occurs. In order to extinguish this afterimage, it might be sufficient if generation of the potential well Φ_{TGE} is prevented in the transfer gate section. However, it can be said that, for the following reason, this is substantially practically impossible in the above mentioned structure, and the variation of the afterimage amount becomes large.

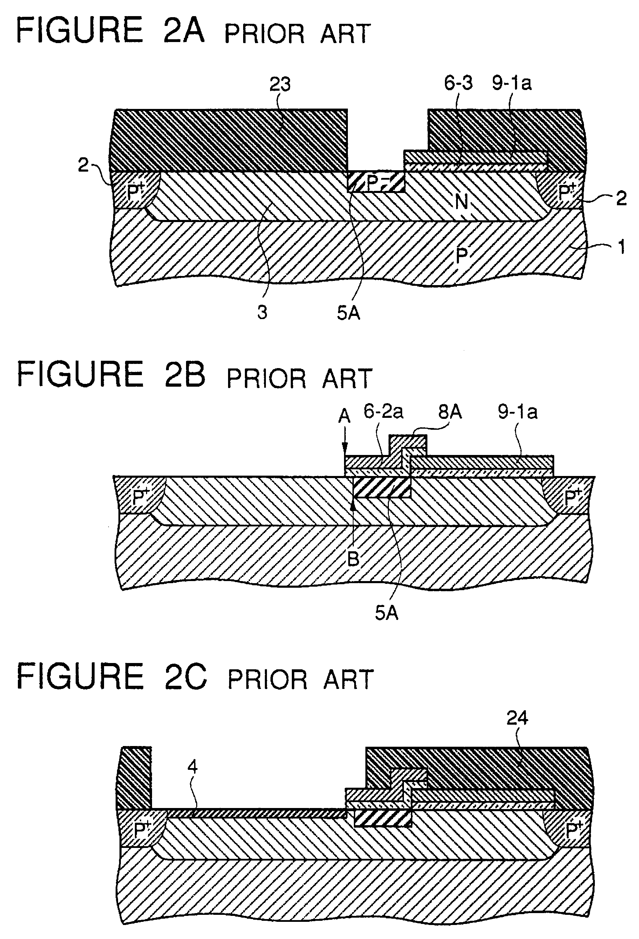

Figures 2A to 2B are sectional views for illustrating a process of the method for manufacturing the solid state image sensor shown in Figure 1A. First, as shown in Figure 2A, the N-type region 3 is selectively formed at the surface of the P-type silicon substrate 1, and then, the gate electrode 9-1a for the CCD register is formed on a portion of the substrate surface through a gate insulating film 6-3. Thereafter, by using a patterned photoresist film 23 and the gate electrode 9-1a as a mask, P-type impurity ions are implanted to the surface of the N-type region 3 so as to form the P⁻ region 5A. Then, as shown in Figure 2B, the transfer gate electrode 8A is formed on an upper surface of the P⁻ region 5A through a gate insulating film 6-2a. Here, it is to be noted that a left edge "A" of the transfer gate electrode 8A is not in conformity with a left edge "B" of the P⁻ region 5A. This nonconformity is caused due to an error in alignment between the mask for formation of the transfer gate electrode 8A and the mask for formation of the P⁻ region 5A. On the other hand, it can be regarded that a left edge of the gate electrode 9-1a of the CCD register is in conformity with a right edge of the P⁻ region 5A. This is because the right edge of the region implanted with the P-type impurity ions is determined by the left edge of the gate electrode 9-1a of the CCD register, in a so-called self-alignment.

Thereafter, as shown in Figure 2C, by using a patterned photoresist film 24 and the transfer gate electrode 8A as a mask, P-type impurity ions are implanted so as to form the P⁺ surface region 4. Here, a right edge of the P⁺ region 4 is substantially in conformity with the left edge of the transfer gate electrode 8A. Explanation of processes succeeding to the above mentioned processes will be omitted since those processes have no relation with the point of the present invention.

As mentioned above, the left edge of the transfer gate electrode 8A and the left edge of the P⁻ region 5A are ordinarily not in conformity with each other, because of the error in the mask alignment. As a result, the deep potential well has occurred at a portion of the transfer gate section.

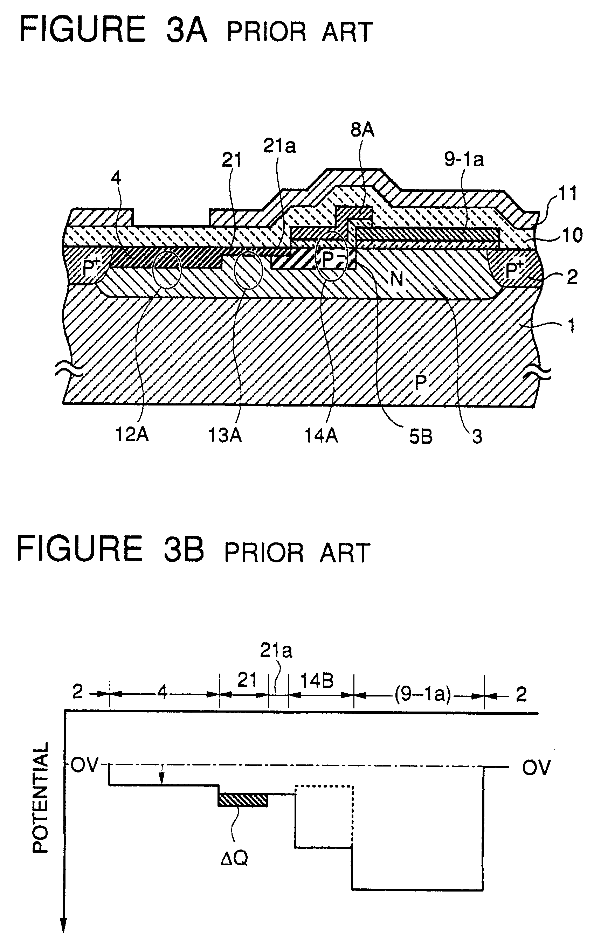

If the nonconformity portion was generated as shown in Figure 3A, differently from Figure 1A, namely, if the ion implantation is performed in such a manner that a left edge of a P⁻ region 5A is positioned on the left hand of the left edge of the transfer gate electrode 8A, a shallow potential portion 21a is formed at a transfer gate side portion of the P⁺ surface region 21. Accordingly, also in this case, all of the signal charges accumulated in the charge storage section 13A is not transferred to the CCD register section, and therefore, a residual electric charge ΔQ exists as shown in Figure 3B, with the result that the afterimage becomes more remarkable than that of the case shown in Figure 1A.

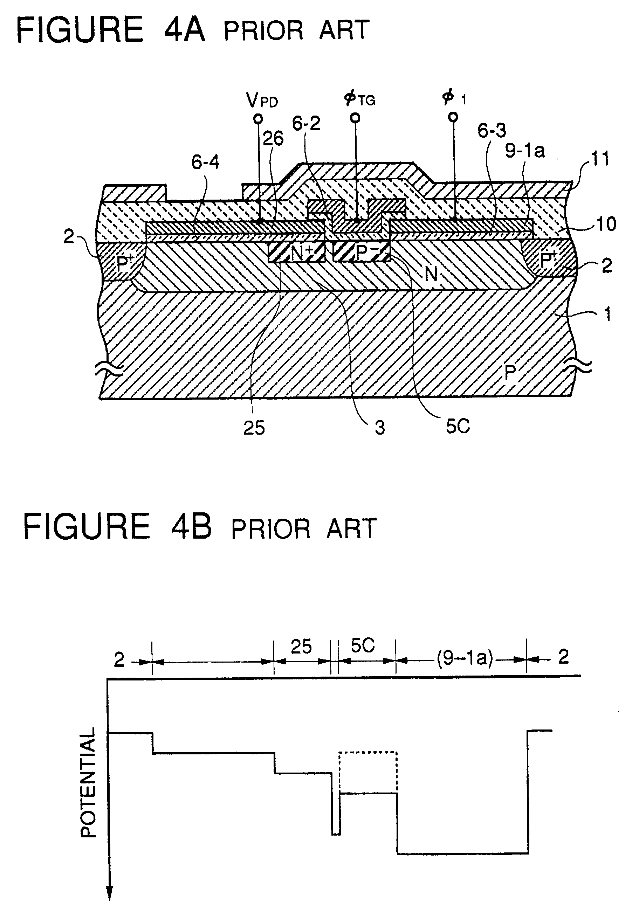

As another example of the conventional solid state image sensors, there has been known a device having a structure as shown in Figure 4A.

This example has a photo gate electrode 26 formed on the N-type region 3 through a gate insulating film 6-4. A positive voltage V_{PD} is applied to this photo gate electrode 26, so that a photoelectric conversion section is formed. An N⁺ region 25 is formed under the photo gate electrode 26 and adjacent to a P⁻ region 5C, so as to form an electric charge storage section. However, as shown in a potential diagram of Figure 4B, since a right edge of the N⁺ region 25 is not necessarily in conformity with a right edge of the photo gate electrode 26 because of a mask alignment error, the afterimage characteristics also has variation.

As mentioned above, the conventional solid state image sensors are possible in principle to reduce the afterimage, but, since the actual afterimage characteristics greatly varies dependently upon the alignment precision, those have been bad in reproducibility.

### Summary of the Invention

Accordingly, it is an object of the present invention to provide a solid state image sensor which has overcome the above mentioned defect of the conventional one.

Another object of the present invention is to provide a solid state image sensor having the afterimage characteristics which is greatly improved and which has reproducibility.

The above and other objects of the present invention are achieved in accordance with the present invention by a solid state image sensor comprising:
a semiconductor substrate of a first conductivity type;
a photoelectric conversion section formed at a principal surface of the semiconductor substrate and for generating signal charges as a function of an incident light, the photoelectric conversion section being composed of a first region of a second conductivity type opposite to the first conductivity type, selectively formed in said principal surface of the semiconductor substrate, and a second region of the first conductivity type selectively formed in a surface of the first region;
an electric charge storage section formed at the principal surface of the semiconductor substrate and for receiving the signal charges from the photoelectric conversion section, the charge storage section being composed of a storage gate electrode formed through a first gate insulating film on the first region adjacent to the second region, and a means for applying a negative potential to the storage gate electrode;
a transfer gate section formed at the principal surface of the semiconductor substrate and for receiving the signal charges from the charge storage section at a predetermined timing, the transfer gate section including a third region of the first conductivity type, selectively formed in a surface of the first region adjacent to the charge storage section, a transfer gate electrode formed on the third region through a second gate insulating film, and a mean for applying a predetermined clock pulse to the transfer gate electrode; and
an electric charge transfer section formed at the principal surface of the semiconductor substrate and for receiving the signal charges from the transfer gate section at a predetermined timing, the electric charge transfer section being composed of a gate electrode formed through a third gate insulating film on the first region adjacent to the third region of the transfer gate section.

The above and other objects, features and advantages of the present invention will be apparent from the following description of preferred embodiments of the invention with reference to the accompanying drawings.

### Brief Description of the Drawings

Figure 1A is a sectional view of one example of conventional solid state image sensors;
Figure 1B is a diagram illustrating a potential profile of the substrate surface in the conventional solid state image sensor shown in Figure 1A;
Figures 2A to 2C are sectional views for illustrating a process of the method for manufacturing the solid state image sensor shown in Figure 1A;
Figure 3A is a sectional view showing a modification of the conventional solid state image sensor shown in Figure 1A;
Figure 3B is a diagram illustrating a potential profile of the substrate surface in the conventional solid state image sensor shown in Figure 3A;
Figure 4A is a sectional view of another example of conventional solid state image sensors;
Figure 4B is a diagram illustrating a potential profile of the substrate surface in the conventional solid state image sensor shown in Figure 4A;
Figure 5 is a layout plan view diagrammatically illustrating one embodiment of the solid state image sensor in accordance with the present invention;
Figure 6A is sectional view taken along the line A-A in Figure 5;
Figure 6B is a potential diagram used for illustrating the solid state image sensor shown in Figure 5;
Figure 7 is a timing chart used for illustrating the operation of the solid state image sensor shown in Figure 5;
Figure 8 shows a potential profile in a depth direction of the respective sections (12, 13, 14) of the solid state image sensor shown in Figure 5;
Figures 9A to 9H are sectional views illustrating a method for illustrating the solid state image sensor shown in Figure 5;
Figure 10A is a diagrammatic plan view of the dual-channel type line image sensor which is a modification of the one embodiment of the present invention; and
Figure 10B is a circuit diagram of a negative voltage generating circuit associated with the solid state image sensor shown in Figure 10A.

### Description of the Preferred embodiments

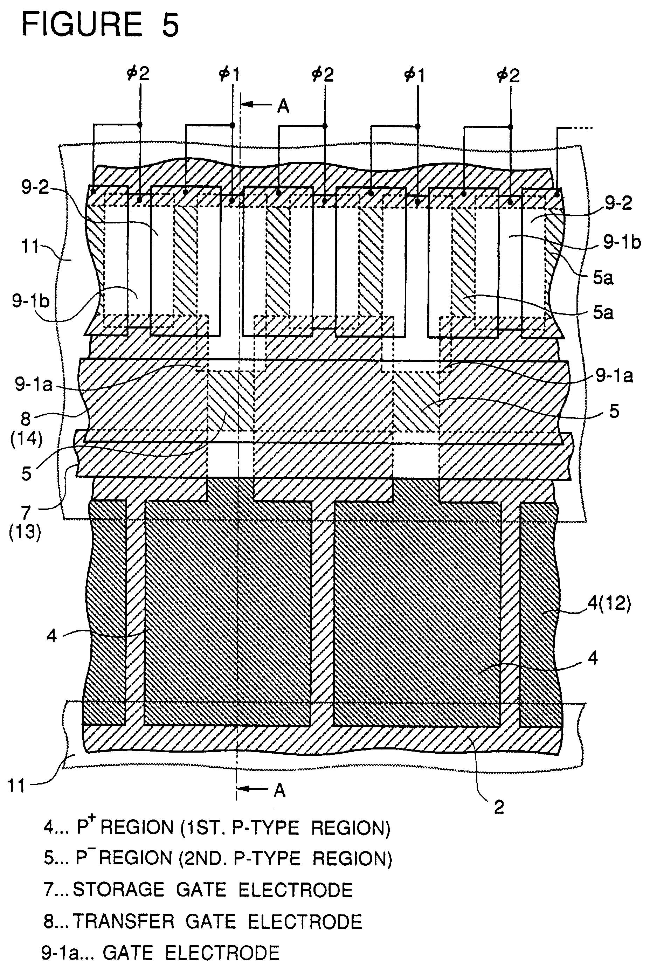

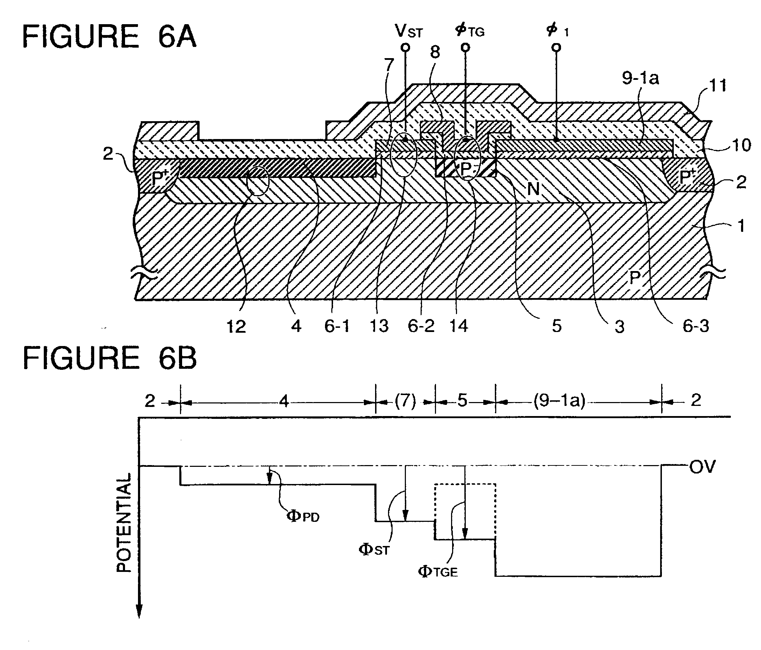

Referring to Figure 5, there is shown a layout plan view diagrammatically illustrating one embodiment of the present invention. Figure 6A is sectional view taken along the line A-A in Figure 5. Figure 6B is a potential diagram used for illustrating the embodiment of the present invention. Figure 7 is a timing chart used for illustrating the operation of the embodiment of the present invention.

The shown embodiment includes a photoelectric conversion section 12 for generating signal charges as a function of an incident light. This photoelectric conversion section 12 is composed of an N-type region 3 selectively formed in a surface of a P-type silicon substrate 1 and a P⁺ region 4 (first P-type region; indicated by the hatching in a lower-right direction in Figure 5 for convenience) selectively formed in a surface of the N-type region 3. The shown embodiment also includes an electric charge storage section 13 for receiving the signal charges from the photoelectric conversion section 12. This charge storage section 13 is composed of a storage gate electrode 7 formed through a first gate insulating film 6-1 on the N-type region 3 adjacent to the P⁺ region 4, and a means for applying a negative potential V_{ST} to the storage gate electrode 7. Furthermore, the shown embodiment includes a transfer gate section 14 for receiving the signal charges from the charge storage section 13 at a predetermined timing t₂. This transfer gate section 14 includes a P⁻ region 5 (second P-type region; indicated by the coarse hatching in a lower-right direction in Figure 5 for convenience) selectively formed in a surface of the N-type region 3 adjacent to the charge storage section 13, a transfer gate electrode 8 formed on the P⁻ region 5 through a second gate insulating film 6-2, and a mean for applying a predetermined clock pulse φ_{TG} to the transfer gate electrode 8. In addition, the shown embodiment includes an electric charge transfer section for receiving the signal charge from the transfer gate section 14 at a predetermined timing t₂. This electric charge transfer section is composed of a gate electrode 9-1a formed through a third gate insulating film 6-3 on the N-type region 3 adjacent to the P⁻ region 5 of the transfer gate section 14.

In the charge storage section 13 of the shown embodiment, there does not exist the shallow P⁺ region 21 of the conventional example shown in Figure 1A, but the storage gate electrode 7 is formed on the substrate surface. In addition, opposite sides of the transfer gate electrode 8 overlap the storage gate electrode 7 and the gate electrode 9-1a of the CCD register.

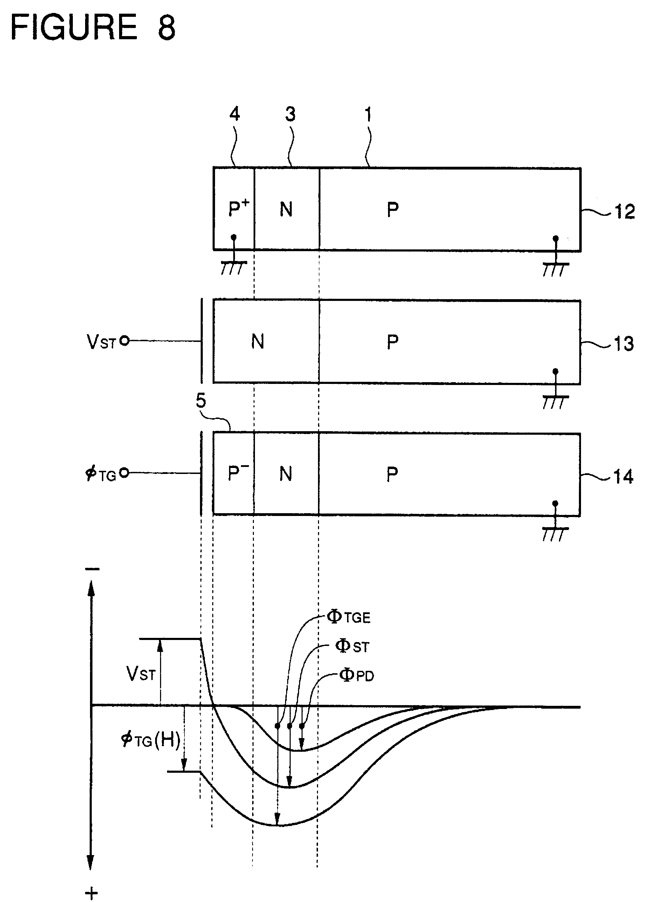

Figure 8 shows a potential profile in a depth direction of the respective sections (12, 13, 14) of the shown solid state image sensor. Since the N-type region 3 is depleted in each of these sections, and since the lowest potential portion is a so-called buried channel existing the internal body of the substrate, the mobility of the charge is large. Comparing the photoelectric conversion section 12 with the charge storage section 13, the N-type region 3 is thicker in the charge storage section 13 than in the photoelectric conversion section 12, and further, the storage gate electrode 7 is supplied with a sufficient negative potential (for example, V_{ST} = -8V) to make the substrate surface potential under the storage gate electrode 7 equal to that of the substrate electrode.

Therefore, as can be seen from the potential diagram of Figure 8, the depth Φ_{ST} of the potential well of the charge storage section 13 is larger than the depth Φ_{PD} of the potential well of the photoelectric conversion section 12. Furthermore, it is designed that when a high level voltage φ_{TG(H)} of the clock φ_{TG} is applied to the transfer gate electrode 8 (the clock φ_{TG} at the timing t₂ in Figure 7), the depth Φ_{TGH} of the potential well of the transfer gate section 14 is larger than the depth Φ_{ST} of the potential well of the charge storage section 13. Incidentally, the dotted line in Figure 6B shows the potential when φ_{TG} is at a low level "L".

In this solid state image sensor, the electric charge generated in the photoelectric conversion section 12 is temporarily accumulated in the charge storage section 13 having the potential well depth larger than that of the photoelectric conversion section 12. This electric charge is read out toward the region under the gate electrode 9-1a by controlling the potential of the transfer gate electrode 8 (so as to cause Φ_{TGH} is deeper than Φ_{ST} but shallower than the potential under the gate electrode 9-1a of the CCD register at the timing t₂). In this charge moving process, in a charge passing path there is formed no deep potential well other than those inherent in the respective regions, differently from the conventional example. Therefore, the charge is quickly transferred, and the generation of the afterimage is prevented.

Now, explanation will be made about why there is formed no deep potential well other than those inherent in the structure of the solid state image sensor.

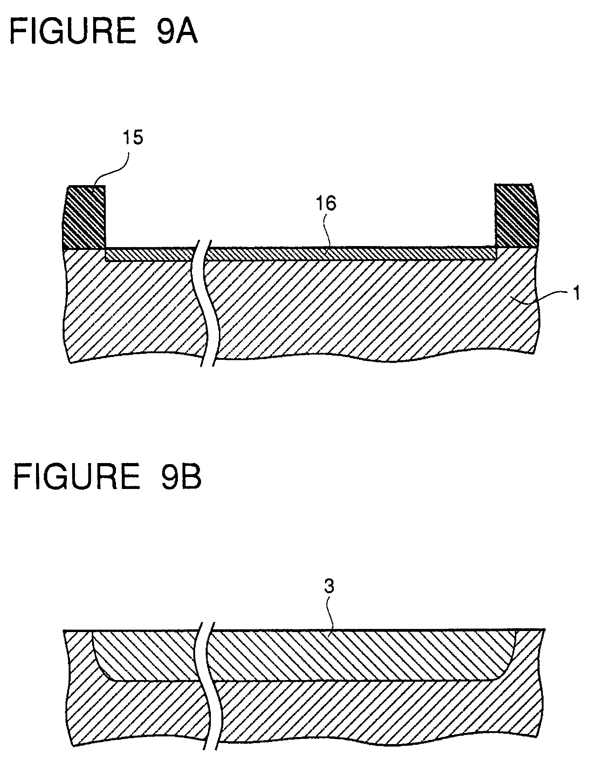

Figures 9A to 9H are sectional views illustrating a method for illustrating the one embodiment of the present invention.

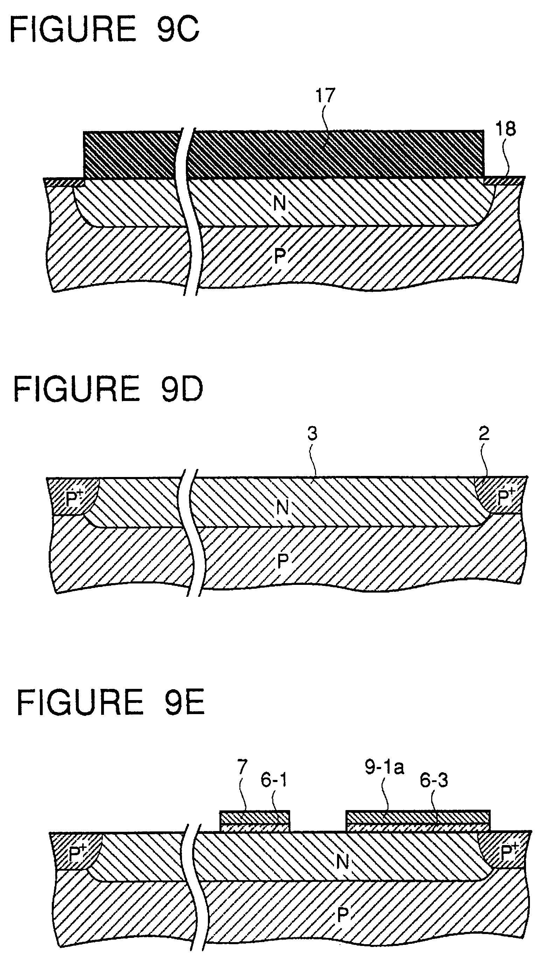

As shown in Figure 9A, an ion doped layer 16 is formed by implanting N-type impurity ions such as phosphorus ions at a dose of 1×10¹²/cm² at an acceleration energy of 100 KeV, using a photoresist film 15 as a mask. Then, a heat treatment is performed at 1000°C for about three hours, so as to form the N-type region 3 having the depth of about 1 µm and the impurity concentration of 5×10¹⁶/cm³, as shown in Figure 9B. Thereafter, as shown in Figure 9C, in order to form a channel stopper region 2 (indicated by the hatching in a lower-right direction in Figure 5), an ion doped layer 18 having the impurity concentration on the order of 1×10¹⁸/cm³ is formed by implanting P-type impurity ions such as boron ions at an acceleration energy of 100 KeV, using a photoresist film 17 as a mask. Then, a heat treatment is performed at 1000°C for about three hours, so as to form the channel stopper region 2 having the impurity concentration of about 1×10¹⁷/cm³, as shown in Figure 9D. At this time, the impurity concentration of the N-type region 3 has become about 2×10¹⁶/cm³. Furthermore, a silicon oxide film having its thickness of 100 nm is formed, and then, a phosphorus doped polysilicon film having its thickness of 500 nm is deposited. These deposited films are patterned to form the storage gate 7 and the gate electrodes 9-1a and 9-1b of the CCD register as shown in Figures 5 and 9E.

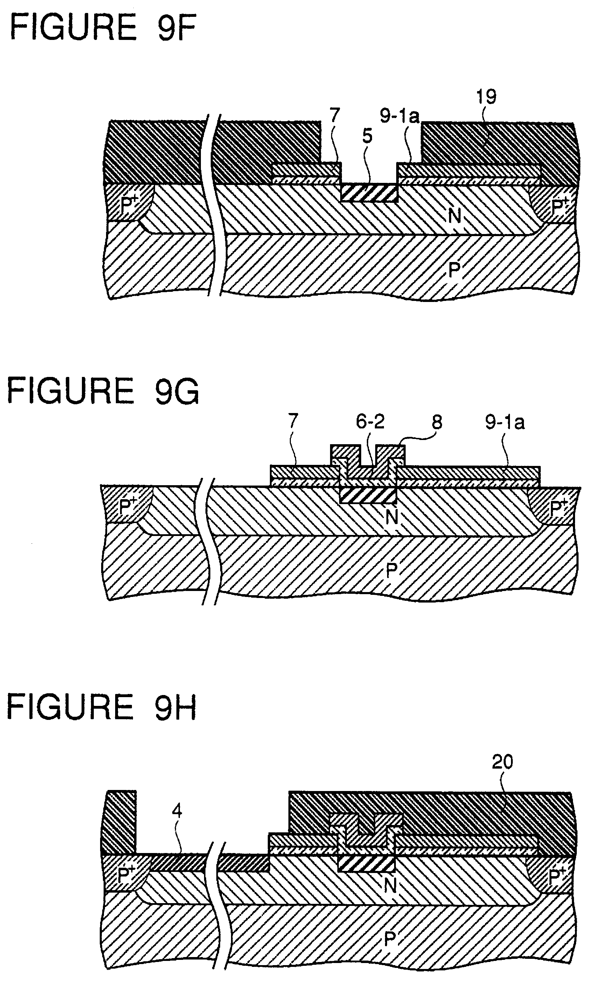

Thereafter, as shown in Figures 5 and 9F, in order to form the P⁻ region 5 (the impurity concentration of about 5×10¹⁵/cm³), boron is implanted using a photoresist film 19, the storage gate electrode 7 and the gate electrode 9-1a as a mask. Similarly, a barrier layer 5a (the impurity concentration of 1×10¹⁶/cm³) is formed. Here, a left edge and a right edge of the P⁻ region 5 are actually in conformity with a right edge of the storage gate electrode 7 and a left edge of the gate electrode 9-1a of the CCD register, respectively. This is because the region implanted with the P-type impurities is confined by those gate electrodes, namely, the region is formed in a self alignment manner.

Thereafter, a silicon oxide film having its thickness of 100 nm, and a phosphorus doped polysilicon film having its thickness of 500 nm are deposited in the named order, and then, patterned to form the transfer gate electrode 8 and a gate electrode 9-2 of the CCD register, as shown in Figures 5 and 9G. The transfer gate electrode 8 overlaps the storage gate electrode 7 and the gate electrode 9-1a of the CCD register, respectively. In addition, as mentioned hereinbefore, tile P⁻ region 5 is formed completely under the transfer gate electrode 8, and no P⁻ region 5 is formed under the storage gate electrode 7 and the gate electrode 9-1a of the CCD register. Accordingly, at a boundary between the regions there is not formed a deep potential well which was formed in the conventional example.

Then, as shown in Figures 5 and 9H, in order to the P⁺ region 4 (having its depth of 300 nm and its impurity concentration of about 2×10¹⁶/cm³), boron ions are implanted using a photoresist film 20 and the storage gate electrode 7 as a mask.

Because of a self-alignment, a right edge of this P⁺ region 4 is actually in conformity with a left edge of the storage gate electrode 7. Accordingly, no deep potential well is formed at a boundary between the photoelectric conversion section and the charge storage section.

As shown in Figure 6A, the interlayer insulating film 10 is formed, and an aluminum film is deposited and then patterned to form the light shield 11 (outlined by the double-dotted chain line in Figure 5 for convenience).

Thus, a single channel type line image sensor has been described. However, the present invention can be applied to a dual-channel type line image sensor.

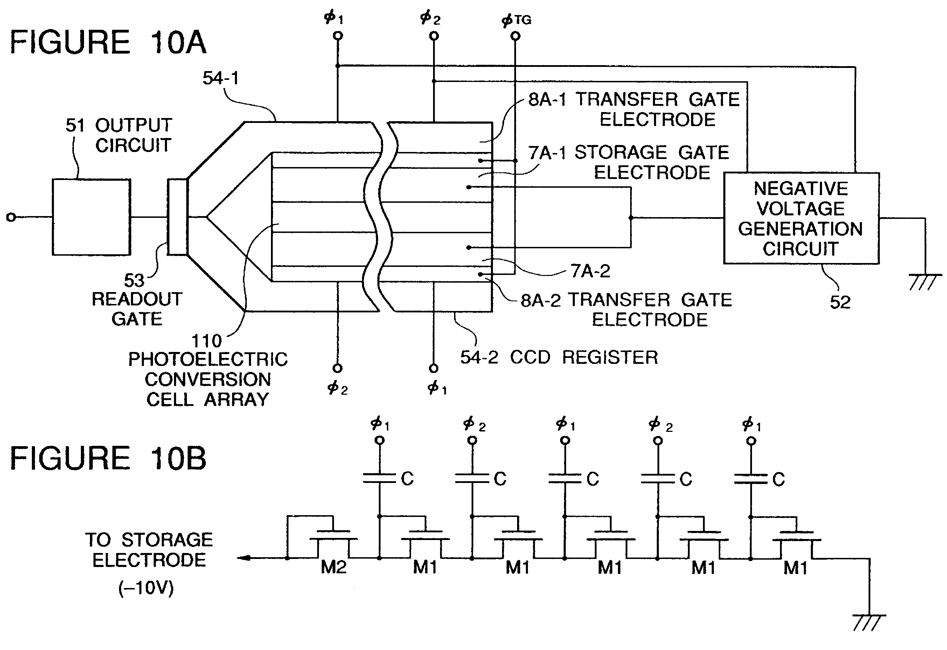

Figure 10A is a diagrammatic plan view of the dual-channel type line image sensor which is a modification of the one embodiment of the present invention. Figure 10B is a circuit diagram of a negative voltage generating circuit.

A central photoelectric conversion cell array 110 is composed of a plurality of photoelectric conversion sections which are similar to the first embodiment as mentioned above and which are arranged in the form of a signal array. However, these photoelectric conversion sections are alternately coupled to a CCD register 54-1 and a CCD register 54-2. Since the central photoelectric conversion cell array 110 is similar to that of a conventional dual-channel type line image sensor, its detailed explanation will be omitted.

The voltage V_{ST} applied to storage gate electrodes 7A-1 and 7A-2 is supplied from a negative voltage generating circuit 52, which is formed of capacitors C and MOS transistors M1 so as to form a charge pump circuit similar to a BBD from the viewpoint of a circuit. A MOS transistor M2 is provided for preventing a reverse direction current, and therefore, is not necessarily required. φ₁ and φ₂ constitute a double phase clock for driving the CCD register (See Figure 7). With this arrangement, the solid state image sensor needs no special external negative voltage. Accordingly, this feature is very convenient. It is a matter of course that this negative voltage generating circuit can be used in the first embodiment mentioned hereinbefore. Transfer gate electrodes 8A-1 and 8A-2, the storage gate electrodes 7A-1 and 7A-2, and the CCD registers 54-1 and 54-2 have constructions similar to corresponding ones of the first embodiment. The signal charges transferred through the CCD registers 54-1 and 54-2 are outputted through a read-out gate 53 from an output circuit 51 to an external.

As mentioned above, the present invention is characterized in that, in a solid state image sensor in which not only a photoelectric conversion section but also a transfer gate section and a charge transfer section are formed in the same N-type (or P-type) region, a P-type (or N-type) region for controlling a channel potential of the transfer gate section is formed in self-alignment with the storage gate electrode and the gate electrode of the charge transfer section. With this arrangement, since there is formed no potential well other than the potential well inherent in the transfer gate section, the movement of the electric charge is smoothly carried out, and therefore, the generation of the afterimage is effectively prevented.

The invention has thus been shown and described with reference to the specific embodiments. However, it should be noted that the present invention is in no way limited to the details of the illustrated structures but changes and modifications may be made within the scope of the appended claims.

## Claims

1. A solid state image sensor comprising;
a semiconductor substrate of a first conductivity type;
a photoelectric conversion section formed at a principal surface of said semiconductor substrate and for generating signal charges as a function of an incident light, said photoelectric conversion section being composed of a first region of a second conductivity type opposite to said first conductivity type, selectively formed in said principal surface of said semiconductor substrate, and a second region of said first conductivity type selectively formed in a surface of said first region;
an electric charge storage section formed at said principal surface of said semiconductor substrate and for receiving the signal charges from said photoelectric conversion section, said charge storage section being composed of a storage gate electrode formed through a first gate insulating film on said first region adjacent to said second region, and a means for applying a negative potential to said storage gate electrode;
a transfer gate section formed at said principal surface of said semiconductor substrate and for receiving the signal charges from said charge storage section at a predetermined timing, said transfer gate section including a third region of said first conductivity type, selectively formed in a surface of said first region adjacent to said charge storage section, a transfer gate electrode formed on said third region through a second gate insulating film, and a mean for applying a predetermined clock pulse to said transfer gate electrode; and
an electric charge transfer section formed at said principal surface of said semiconductor substrate and for receiving the signal charges from said transfer gate section at a predetermined timing, said electric charge transfer section being composed of a gate electrode formed through a third gate insulating film on said first region adjacent to said third region of said transfer gate section.

2. A solid state image sensor claimed in Claim 1 wherein said third region is in a self-alignment with said storage gate electrode and said gate electrode of said electric charge transfer section.

3. A solid state image sensor claimed in Claim 2 wherein said electric charge transfer section is composed of a CCD register formed at said principal surface of said semiconductor substrate.

4. A solid state image sensor claimed in Claim 3 further including a negative voltage generating circuit receiving a multiphase clock for driving said CCD register for generating said negative potential to said storage gate electrode, said negative potential having a magnitude for making a substrate surface potential under said storage gate electrode substantially equal to that of said substrate itself.
